(19) Europäisches Patentamt / European Patent Office / Office européen des brevets

(11) **EP 2 981 866 B1**

(12) **EUROPEAN PATENT SPECIFICATION**

(45) Date of publication and mention
of the grant of the patent:
**11.03.2020 Bulletin 2020/11**

(51) Int Cl.:
**G05B 13/04** *(2006.01)* **G06F 17/50** *(2006.01)*
**E21B 41/00** *(2006.01)*

(21) Application number: **13885397.3**

(22) Date of filing: **24.05.2013**

(86) International application number:
**PCT/US2013/042711**

(87) International publication number:
**WO 2014/189523 (27.11.2014 Gazette 2014/48)**

(54) **METHODS AND SYSTEMS FOR RESERVOIR HISTORY MATCHING FOR IMPROVED ESTIMATION OF RESERVOIR PERFORMANCE**

VERFAHREN UND SYSTEME FÜR RESERVOIRVERLAUFSABGLEICH ZUR VERBESSERTEN SCHÄTZUNG EINER RESERVOIRLEISTUNG

PROCÉDÉS ET SYSTÈMES PERMETTANT DE METTRE EN CORRESPONDANCE UN HISTORIQUE DE RÉSERVOIR POUR UNE MEILLEURE ÉVALUATION DES PERFORMANCES DE RÉSERVOIR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.02.2016 Bulletin 2016/06**

(73) Proprietor: **Halliburton Energy Services Inc.**
**Houston, Texas 77032 (US)**

(72) Inventors:
• **SINGH, Ajay Pratap**
**Houston, TX 77077 (US)**
• **NIKOLAOU, Michael**
**Houston, TX 77077 (US)**

• **SAPUTELLI, Luigi**
**Houston, TX 77098 (US)**
• **MAUCEC, Marko**
**Englewood, Colorado 80111 (US)**

(74) Representative: **Jennings, Michael John et al**
**A.A. Thornton & Co.**
**10 Old Bailey**
**London EC4M 7NG (GB)**

(56) References cited:
US-A- 5 335 291    US-A1- 2007 016 389
US-A1- 2008 077 371    US-A1- 2012 253 770
US-A1- 2013 080 066    US-A1- 2013 080 066
US-B1- 6 523 015    US-B1- 6 523 015
US-B1- 6 611 726    US-B1- 6 611 726

**Description**

TECHNICAL FIELD

The disclosures herein pertain generally to reservoir modeling. Some examples relate to predictive modeling.

BACKGROUND

Mathematical models are currently used by engineers to make estimations of future oil and gas production from underground hydrocarbon reservoirs. Such models typically involve solving a collection of differential equations to arrive at the desired estimations. Typically, a number of reservoir-related parameters appear in these equations, such as rock permeability, porosity, relative permeability and others. These models are often executed by a computer, which often takes the values of these parameters as input for purposes of solving the differential equations.

To estimate the values of these inputted parameters, engineers typically rely on historical production data (production rates, pressures, etc.), which, in many cases, is available from some observational point in the past up to a later time, in some cases the present. During parameter estimation from historical production data, parameter values associated with a target geological region (e.g. an underground hydrocarbon reservoir and the surrounding geological material) are adjusted so that the solution of the corresponding equations, from the beginning of production up to the latest point in time, matches the historical production data. This exercise is known as "history matching." The underlying rationale for history matching is that if parameter values are adjusted in a way that produces the best possible match between historical production data and model-generated production data then the resulting model will most likely provide the best production estimations into the future.

There are, however, several limitations associated with these history matching techniques. For example, one key limitation is that excellent history matching does not universally result in excellent future production data predictions. This situation is all too common in model building, and has many facets. In the simplest example, one could think of building a model of the form $y = F(t)$ to match the observed production values of $y_1$ to $y_n$ at $n$ time points $t_1$ to $t_n$ by simply considering a function $F$ with $n$ or more geological parameters (*e.g.* porosity, permeability, etc.). However, without any additional structure, such a function $F$ would be essentially useless for making any estimation on $y$ at a future time $t$.

When building a model for a hydrocarbon reservoir, a typical model would entail millions of parameter values, each corresponding to parameters in one of the millions of small blocks into which the reservoir is discretized, for numerical solution of corresponding equations. However, the production history can, at best, include daily values over a few decades-namely, at most, a few tens of thousands of data points. Consequently, when performing history matching-based parameter estimation, one is faced with problem estimating millions of parameter values using only thousands of data points. Such a problem is unsolvable, *per se.* To become solvable, the problem must somehow be modified using additional information. A variety of approaches to such modification exist. For example, in the Bayesian approach, a prior probability distribution is assumed for the parameters to be estimated. Typical sources for such *a priori* information include geological models of the reservoir. Available historical production data is subsequently used to update that prior probability distribution, for example, to generate a posterior probability distribution of the estimated parameters. This approach is computationally demanding and can be implemented in a number of ways. In one implementation, referred to as ensemble-based history matching, the posterior probability distributions are generated numerically. While other approaches exist as well, they each require an unattractive computational load. Hence, modern reservoir history matching algorithms have focused on expediting computations needed for estimation of reservoir model parameters.

Typically, these algorithms rely on parameter compression techniques known as reparameterization, streamline sensitivities calculation to increase the acceptance rate, and high performance computing in order to accommodate higher resolution geologic models. Common parameterization techniques involve mathematical transformations such as principal component analysis, kernel principal component analysis, discrete cosine transformation, adaptive spatial zonation, and coarsening of the reservoir model. However, the rationale for reparametrization, namely for the choice of model complexity and size of parameter space (*i.e.* degree of compression) is based on prior knowledge (*i.e.* optimal compression which can reproduce the original parameter estimates with insignificant error). As a result, these parameterization techniques are relatively ill-equipped for estimation of the values of reservoir parameters so that future production predictions are reliable. Thus, improved history matching methods are needed for improving the prediction capability of reservoir models. US2013080066 discloses a reservoir properties prediction with least square support vector machine.

SUMMARY

The present disclosure presents methods and apparatus for improved estimation of reservoir performance, for example, such as prediction of future oil or gas production rates and pressures. As described herein, these methods and apparatus use cross-validation to determine an optimum number of parameters and numerical values of parameters upon which to base a production forecasting model. For example, the present disclosure describes a method of determining a geological model which may include the act of identifying an array of parameter sets, wherein each parameter set is of a unique size and contains values of geological parameters estimated from historical production data associated with a target geological region. Additionally, such an example method may include determining a fitting error between a first set of the historical production data and modeled production data, wherein the modeled production data is obtained via execution of a simulation model based on each parameter set of the array, determining a validation error between a second set of the historical production data and extrapolated production data for each parameter set of the array, wherein the extrapolated production data is obtained based on the modeled production data for the respective parameter set of the array, and determining a combined error for each parameter set of the array based on the fitting error and the validation error. In addition, the example method may include identifying an optimal parameter set size for modeling the target geological region, wherein the optimal parameter set size is determined in reference to a minimum combined error of the combined errors determined for each parameter set of the array.

The above examples of the present disclosure present merely examples that will be further described and expanded in the detailed description and in view of the Figures presented below.

BRIEF DESCRIPTION OF THE DRAWINGS

FIG. 1 is a graphical representation of a modeled production data vector over time;
FIG. 2 is a similar graphical representation of a modeled production data vector over time;
FIG. 3 is a graphical representation displaying a combined error in relation to fitting error and validation error;
FIG. 4 is a block diagram illustrating a computer device for production data estimation;
FIG. 5 is a block diagram illustrating a module for production data estimation;
FIG. 6 is a flow diagram illustrating an example method of production data estimation in an example of the disclosure;
FIG. 7 is a block diagram illustrating an example grouping of electrical modules for production data estimation; and
FIG. 8 is a block diagram illustrating a machine in the example form of a computer system, within which a set or sequence of instructions for causing the machine to perform any one of the methodologies discussed herein may be executed, according to an example embodiment.

DETAILED DESCRIPTION

The present disclosure presents methods, apparatuses, and systems for estimating parameter values of a target geological region, which may contain one or more underground reservoirs, based on cross-validation techniques in order to improve forecast capability of a simulation model based on estimated parameter values of a target geological region. For example, the present disclosure proposes a method for identifying an optimum number and numerical values of parameters in a simulation model, through cross-validation. As used herein, the term "optimal" is used in the relative sense in regard to parameter sets to identify a preferable parameter set, out of identified possibly applicable data sets, for use in methods as generally disclosed herein, and not in the absolute sense that no other possible parameter set could possibly be "better" (i.e., could provide improved determinations of the types identified herein). Additionally, selection of an "optimal" parameter set may, unless otherwise specifically identified herein, be based on data or considerations in addition to addition to those identified herein. As a result, such example methods of the disclosure provide a new formulation of the optimization problem for history matching that considers the optimization of several variables, which may include, but are not limited to: a number of model parameters, fitting error, and validation error. Such an approach can achieve several objectives, including (1) avoidance of high resolution models that require massive processing power and (2) an increase in the production forecasting capability of the reservoir model of a target geological region.

The following description refers to the accompanying drawings that depict various details of examples selected to show how the present invention may be practiced. The discussion addresses various examples of the inventive subject matter at least partially in reference to these drawings, and describes the depicted embodiments in sufficient detail to enable those skilled in the art to practice the invention. Many other embodiments may be utilized for practicing the inventive subject matter than the illustrative examples discussed herein, and many structural and operational changes in addition to the alternatives specifically discussed herein may be made without departing from the scope of the inventive subject matter.

In this description, references to "one embodiment" or "an embodiment," or to "one example" or "an example" mean that the feature being referred to is, or may be, included in at least one embodiment or example of the invention. Separate references to "an embodiment" or "one embodiment" or to "one example" or "an example" in this description are not intended to necessarily refer to the same embodiment or example; however, neither are such embodiments mutually exclusive, unless so stated or as will be readily apparent to those of ordinary skill in the art having the benefit of this disclosure. Thus, the present invention can include a variety of combinations and/or integrations of the embodiments and examples described herein, as well as further embodiments and examples as defined within the scope of all claims based on this disclosure, as well as all legal equivalents of such claims.

To formulate a model for estimation of optimal size of parameter set, which may include parameters such as, but not limited to, porosity, relative permeability, etc. corresponding to a discretized portion of a target geological region, the methods, apparatus, and systems described herein utilize cross-validation methods. In cross-validation as applied in the description herein, a portion of an observed, historical production value data set is used to estimate parameter values for a certain model structure that fits the model calculated production data to the historical production value data set for some portion of the available historical production data. The resulting parameter estimates are then used to assess how well the remaining portion of the historical production data can be predicted by the model in a so-called validation test. The methods, apparatus, and systems herein may compute and analyze a combined error of the computed fitting error and validation error as an indicator of model quality. After determining an optimal parameter value set size and corresponding values of parameters and/or reliability based on the combined error, the example methods, apparatuses, and systems herein may forecast future production data of a target geological region by modeling the target geological region using the optimal parameter set.

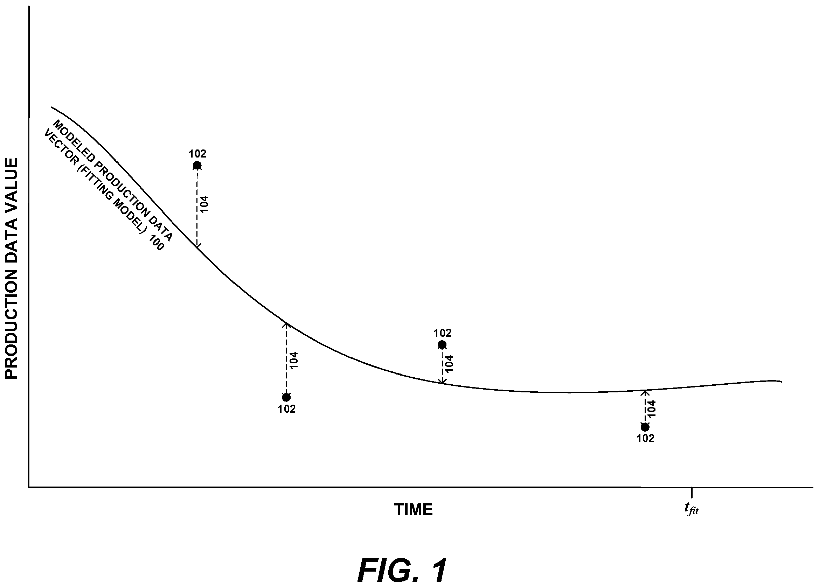

Turning to the figures, FIG. 1 is a graphical representation of a production data vector 100 determined using a fitting model based on a specific parameter set of choice. As indicated, FIG. 1 represents an example of varying modeled production data (y-axis) (*e.g.* oil, water, natural gas production or yield) of an example reservoir over a time interval (x-axis). In an example, the fitting model attempts to estimate a parameter set to determine production data vector 100 that serves as a best fit for historical production data values 102 of the production data (*e.g.* previously measured, or "historical," data values for the target geological region) over a time period preceding time point $t_{fit}$. As used herein, the term "parameter(s)" or "geological parameter(s)" refers to one or more properties of a geological region or formation, such as, but not limited to, porosity, permeability, pressure, or any chemical, electromagnetic, or physical property of the geological region or formation; one or more properties of the fluids therein; and other variables impacting geological region, formation, or reservoir performance, as known to persons skilled in the art. Furthermore, as used herein, the term "target geological region" includes a subsurface region of interest, which may include one or more reservoirs and/or geological formations.

In an example, parameter set estimation of the fitting model may be computed based on minimization of sum of square errors between a first set of historical production data values 102 and modeled production data vector 100 via one or more numerical or mathematical optimization methods, which may include, but are not limited to, parameterization techniques involving mathematical transformations such as principal component analysis, kernel principal component analysis, discrete cosine transformation, adaptive spatial zonation, and coarsening of the reservoir model, or any other numerical optimization method. In an example of a fitting model, as mentioned above, a least-squares based optimization using discrete cosine transformation of the parameter vector $p$ may be implemented to produce an estimate $\hat{p}$ of the parameter vector $p$ according to the following algorithm:

$$\hat{p} = \arg\left\{\min_p\left[\sum_{t=0}^{t_{fit}}\left(d_t - d_t^{model}(\hat{p})\right)^2\right]\right\}$$

where $d_t$ represents an historical production data value 102 and $d_t^{model}$ represents determined value of production vector data (item 100 of FIG. 1) value at time t.

Additionally, production data vector 100 may be computed according to other simulation or modeling techniques, such as, but not limited to, full-physics simulation and/or streamline simulation. In an example, full-physics simulation may include, but is not limited to, gridding and discretization of a geological region (*e.g.* reservoir) geometry, fluid property calculations, displacement modeling, and solving assembling matrix equations over time.

In an example, where gridding and/or discretization methods are utilized, the reservoir is divided into a collection of cells, where the governing equations for multiphase flow may be discretized. Fluid property and displacement modules (*e.g.* associated with a computing device) may compute various quantities and their derivatives needed for assembling the matrix equations during time stepping, which may comprise iterative calculations. Likewise, in some non-limiting examples, streamline simulation ("SLN") may include a process of numerical discretization that may leverage an "inertia" or "trend" of past data points to estimate future data values.

As illustrated in FIG. 1, when a fitting model is constructed, for example, according to one or more of the numerical methods mentioned above, there will typically be a fitting error $f_{fitting}$ (item 104 of FIG. 1) between the historical production data at a point in time t and the value of the modeled production data vector 100 at time t. In the above-recited example where an optimization method is used to construct the modeled production data vector of the fitting model, this error may be obtained according to the following algorithm:

$$f_{fitting} = \sum_{t=0}^{t_{fit}} \left(d_t - d_t^{model}(\hat{p})\right)^2$$

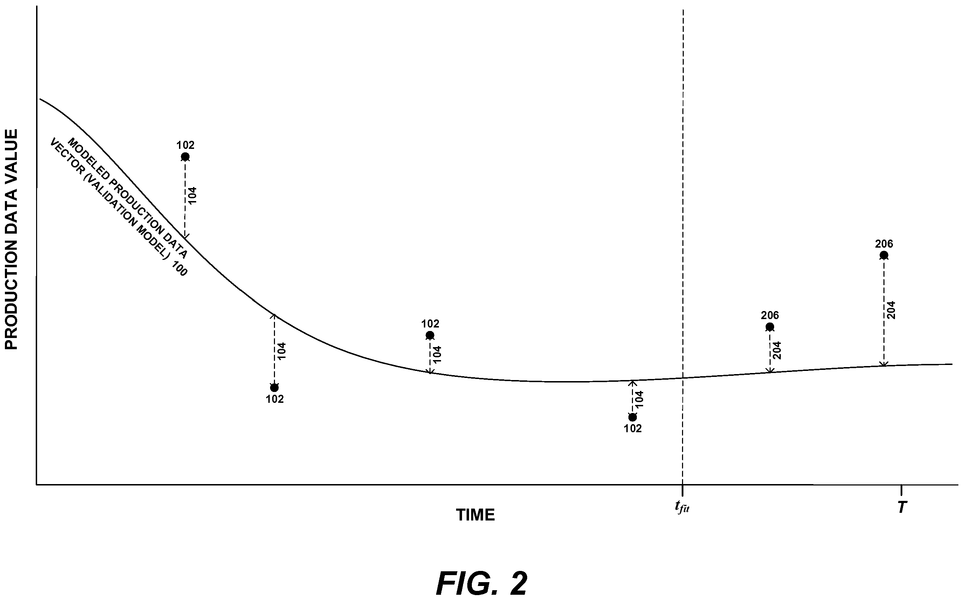

Continuing from FIG. 1, FIG. 2 is a graphical representation of a cross-validation technique for determining a validation error 204 associated with a second set of historical production data values 206 at various times t, which are observed during an interval $t_{fit} < t \le T$. FIG. 2 includes forecast calculation of production data extrapolated from production data vector 100 over time period $t_{fit} < t \le T$ such that production data over this time period are estimated according to the model with parameter values equal to the estimates determined according to the fitting model of FIG. 1. Represented mathematically, the validation error $f_{validation}$ (items 204 of FIG. 2) may be computed according to the following algorithm:

$$f_{validation} = \sum_{t=t_{fit}+1}^{T} \left(d_t - d_t^{model}(\hat{p})\right)^2$$

Furthermore, for purposes of the present disclosure, the terms "extrapolated data," "extrapolated production data," or the like refer to any information, such as production data, that is estimated based on previously measured data values. In one example, "extrapolated production data" refers to production data that is predicted for the time period $t_{fit} < t \le T$ based on previously measured production data values, such as those measured before $t_{fit}$. Similarly, the verb "extrapolate" refers to the act of predicting production data for the time period $t_{fit} < t \le T$ based on previously measured production data values, such as those measured before $t_{fit}$. In addition, for purposes of the present disclosure, the terms "forecast production data" refers to production data that is predicted for a time period after T and based on production data observed before time T. Likewise, the verb "forecast" and "forecasting" refers to the act of predicting production data that is predicted for a time period after T and based on production data observed before time T.

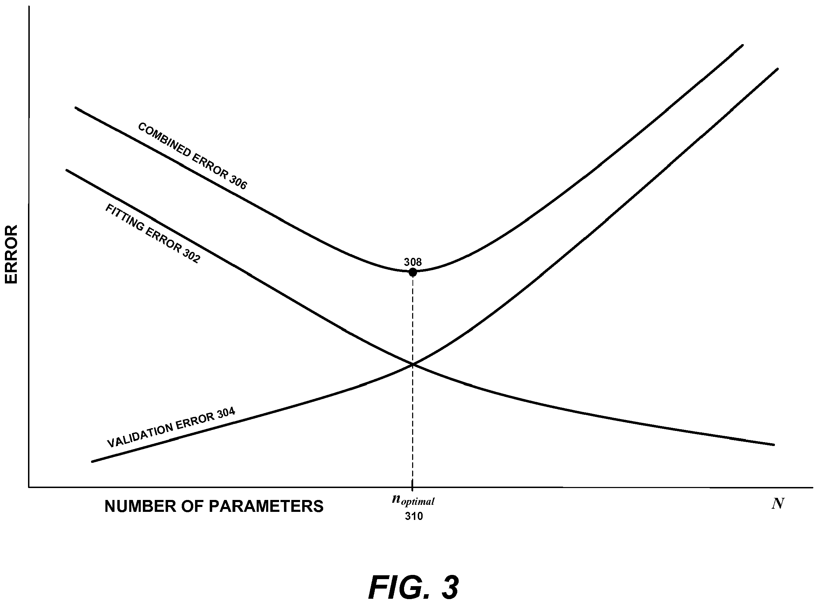

Turning to FIG. 3, the graph of this figure displays a combined error 306 comprised of the sum of the fitting error 302 (see FIG. 1) and the validation error 304 (see FIG. 2) of a variety of parameter models having unique numbers of parameters upon which a production data vector is determined. In other words, FIG. 3 represents a landscape of the combined errors 306 of multiple iterations of fitting and validation model executions described in FIGS. 1 and 2, respectively, wherein each model iteration is computed using a unique number of parameters as input. As might be expected, the fitting error 302 over an observed time period in the past may decrease with a greater number of input parameters, as numerical methods executed with a large number of known input parameters are able to fit a modeled production data vector to the observed data points rather well. This fitting capability, though effective for fitting a vector to a set of known observed (historical) data points over a past time period, is ill-equipped to serve as a sole indicator of future values. This phenomenon is apparent in FIG. 3, where the validation error 302 increases as the number of parameters increases.

To optimally leverage the positive examples of both fitting estimation and validation estimation, one may derive the combined error 306 from the fitting error 302 and validation error 304 across a spectrum of models, each using a varying number of parameters (e.g. $N_{min}$ to N), to obtain an optimal parameter set size $n_{optimal}$ 310.

In the described examples, this optimal parameter set size $n_{optimal}$ 310 corresponds to the parameter set size (i.e. the number of parameters in the set) used for the fitting and validation models that produces a minimum combined error $f_{combined}$ at point 308. In an example, as mentioned above, the combined error for a given number of parameters $n$ of a range $N_{min} \le n \le N$ may be computed by summing the fitting error 302 and validation error 304 associated with models using $n$ parameters, or, represented mathematically, according to the following algorithms:

$$f_{combined}(n) = f_{fitting}(n) + f_{validation}(n)$$

$$f_{combined}(n) = \sum_{t=0}^{t_{fit}} \left(d_t - d_t^{model}(\hat{p}(n))\right)^2 + \sum_{t=t_{fit}+1}^{T} \left(d_t - d_t^{model}(\hat{p}(n))\right)^2$$

Thus, the minimum and optimal combined error (point 308) for the range of different numbers of parameters n may be computed according to the following algorithm:

$$f_{optimal} = \min\left\{{}_{N_{\min}}^{N} \left| f_{combined}(n) \right.\right\} = f_{combined}(n_{optimal})$$

Furthermore, once the optimal combined error 308 is found, the corresponding optimal parameter set size 310 may likewise be obtained and used for estimation of the parameter vector $p$ based on a full historical production data value set *(e.g.* both the first set of historical production data 102 of FIG. 1 and the second set of historical production data 206 of FIG. 2), and, subsequently, future forecast of production data values.

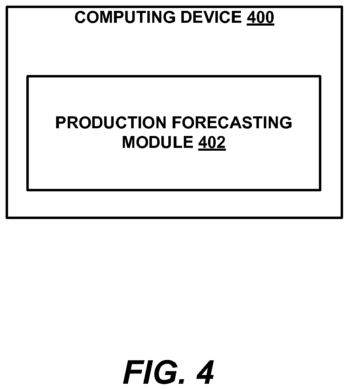

FIG. 4 represents an example computer device 400 that may be configured to forecast future values of one or more production data values associated with a target geological region. In an example, computer device 400 may comprise any electronic device capable of processing data, which may include, but is not limited to, a processor, integrated circuit, desktop computer, laptop computer, smart phone, mobile device, tablet computer, or any other device or electrical module. In addition, computer device 400 may include a production forecasting module 402, which may be configured to execute parameter estimating algorithms and computations, perform data-fitting using numerical methods, compute error values, and forecast production values based on an optimal parameter set size, and corresponding values of parameters and/or perform any of the methods or evaluate any of the algorithms presented herein.

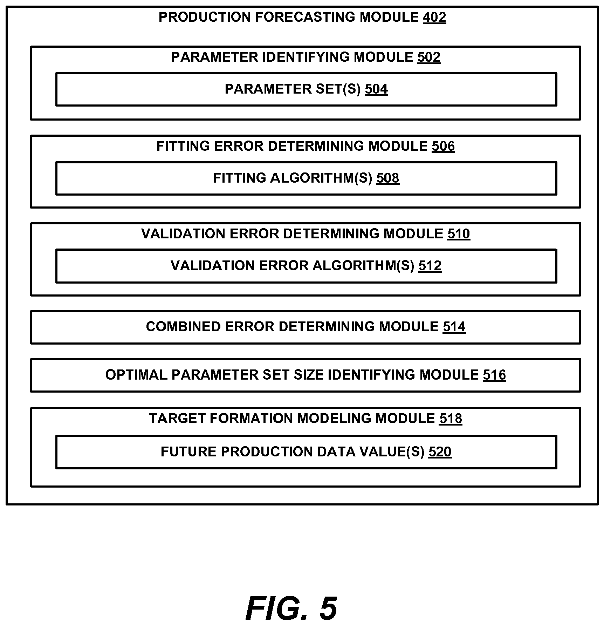

FIG. 4 is a block diagram further illustrating production forecasting module 402 of FIG. 3; and Figure 5 depicts production forecasting module 402 in greater detail. The functionality of production forecasting module 402 is expressed herein in terms of additional sub-modules herein. The described modules of FIGS. 4 and 5 represent conceptual modules representing functionality to be performed. In many examples, this functionality will be achieved through use of instructions encoded in a machine readable storage device for execution by one or more processors, computers or other controllers; and in other examples the functionality will be achieved at least in part through use of other hardware devices. The description of this functionality in terms of "modules" is not intended to imply any distinctness between modules, or any separate hardware or any grouping or segregation of stored instructions or data between such "modules." Although the modules shown in Figure 10 are shown and described as distinct modules, it should be understood that the described functionality may be implemented by any combination of hardware and software as may be desired to provide the described functionality. For example, in examples wherein the functionality of each module of Figure 5 is performed through execution by one or more processors of stored instructions, all such instructions may be stored in one or more machine readable storage devices and executed by one or more processors.

In one example, production forecasting module 402 includes a parameter identifying module 502, which is configured to store or otherwise obtain one or more parameter sets 504. In an example, parameter sets 504 may include parameter sets of different sizes and which correspond to a variety of observed, measured, estimated, modeled, or otherwise obtained parameters associated with one or more points in a target geological region, such as, but not limited to, a geological region that includes a petrochemical reservoir. For example, parameter sets 504 may include parameter values corresponding to porosity, permeability, relative permeability, density, chemical makeup, or any other physical, chemical, magnetic, or electrical characteristic of the one or more points in the geological region.

In an example, parameter identifying module 502 may obtain values of parameter sets 504 of a particular size using observed parameter values, estimated parameter values, or both. In an example, where estimated parameter values are used, parameter identifying module 502 may estimate parameter values by utilizing historical production data values to estimate the values of parameters using one or more methods described herein. For example, parameter identifying module 502 may utilize or work cooperatively with fitting error determining module 506 to estimate parameter values associated with historical production data. Furthermore, parameter sets 504 may include an array of parameter sets, wherein each parameter set of the array contains a unique number of parameters and/or parameter values.

In addition, parameter estimation module may include a fitting error determining module 506, which may be configured todetermine and/or minimize a fitting error associated with one or more executed models. In an example, fitting error determining module 506 may calculate a fitting error by using historical production data values, such as, but not limited to one or both of the first set of historical production data 102 of FIG. 1 and the second set of historical production data 206 of FIG. 2 and corresponding modeled production data vector 100 of FIG. 1. This fitting error may be calculated by using a fitting model estimated by one or more fitting algorithms 508, which may include optimization algorithms to minimize fitting error 104 FIG. 1 based on, but not limited to, parameterization techniques involving mathematical transformations. These may include parameterization techniques such as principal component analysis, kernel principal component analysis, discrete cosine transformation, adaptive spatial zonation, and coarsening of the reservoir model, or any other numerical optimization method. Additionally, one or more simulation models, including but not limited to full-physics or streamline simulation, may be utilized. In an example of a fitting model, as mentioned above, a least-squares based optimization using discrete cosine transformation may be implemented as a fitting algorithm 508 to produce an estimate $\hat{p}$ of the parameter vector $p$ according to the following algorithm:

$$\hat{p} = \arg\left\{\min_p\left[\sum_{t=0}^{t_{fit}}\left(d_t - d_t^{\,model}(\hat{p})\right)^2\right]\right\}$$

where $d_t$ represents an historical production data value *(e.g.* one or both of the first set of historical production data 102 of FIG. 1 and the second set of historical production data 206 of FIG. 2) and $d_t^{\,model}$ represents determined value of production vector data (item 100 of FIG. 1) value at time *t*.

Additionally, fitting error determining module 506 may determine a fitting error associated with a generated fitting model by comparing the modeled production data vector, at a previous time *t,* with each historical production data value obtained at time *t* over an interval preceding a selected fitting time $t_{fit}$. In other words, fitting error determining module 506 may be configured to compute the following algorithm, as described in relation to FIG. 1, above:

$$f_{fitting} = \sum_{t=0}^{t_{fit}}\left(d_t - d_t^{\,model}(\hat{p})\right)^2$$

Furthermore, FIG. 5 may include a validation error determining module 510, configured to determine a validation error according to one or more validation error algorithms 512, which in some examples will include algorithms that perform cross-validation. In some examples, validation error determining module 510 may separate a modeling timeframe into a first sub-timeframe and a second sub-timeframe. In some examples, the modeling timeframe may comprise a time interval beginning at some first measurement point in the past and ending, for example, at a present time *T.* Furthermore, first sub-timeframe may include a time interval preceding a time point $t_{fit}$ and the second sub-timeframe may include a time interval immediately following $t_{fit}$ and ending, in some examples, at point *T.* In other words, for a modeling timeframe spanning a first measurement time point (referred to here as "0") to time *T,* validation error determining module 510 may separate the modeling timeframe into a first sub-timeframe $0 < t \leq t_{fit}$ and a second sub-timeframe $t_{fit} < t \leq T$.

In addition, validation error determining module 510 may further be configured to determine second sub-timeframe modeled production data based on geological parameters estimated during the first sub-timeframe. In other words, validation error determining module 510 may be configured to extrapolate or otherwise predict or forecast modeled production data vector based on a fitting model past time $t_{fit}$ and into second sub-timeframe up to time *T.* In addition, validation error determining module 510 may be configured to compare the second sub-timeframe modeled production data to historical production data *(e.g.* the second set of historical production data 206 of FIG. 2) during the second sub-timeframe to determine the validation error associated with the extrapolated modeled production data vector based on the fitting model over the second sub-timeframe. In an example, this comparison of the second sub-timeframe modeled production data to observed data during the second sub-timeframe may include computing a squared error between the second sub-timeframe modeled production data to the observed data during the second sub-timeframe. Thus, as described in relation to FIG. 1, validation error determining module 510 may be configured to evaluate the following algorithm:

$$f_{validation} = \sum_{t=t_{fit}+1}^{T}\left(d_t - d_t^{\,model}(\hat{p})\right)^2$$

In addition, production forecasting module 402 may include a combined error determining module 514, which may be configured to determine a combined error for a given parameter model based on the fitting error and the validation error. In an example, combined error determining module 514 may determine the combined error by summing the fitting error and the validation error determined by fitting error determining module 506 and validation error determining module 510, respectively. Thus, in an example, combined error determining module may be configured to evaluate the following algorithm for a parameter set consisting of n parameters, as described in relation to FIG. 3, above:

$$f_{combined}(n) = \lambda\sum_{t=0}^{t_{fit}}\left(d_t - d_t^{\,model}(\hat{p}(n))\right)^2 + (1-\lambda)\sum_{t=t_{fit}+1}^{T}\left(d_t - d_t^{\,model}(\hat{p}(n))\right)^2$$

where $\lambda$ represents a scaling factor that may be varied to provide relative weight to either of the fitting error or the validation error.

Furthermore, production forecasting module 402 may include an optimal parameter set size identifying module 516, which may be configured to generate an optimal parameter set size associated with a parameter model that minimizes the combined error of the parameter sets 504 determined by combined error determining module 514. For example, in an example, of multiple models each run using unique numbers of estimated parameter values as input for each model, optimal parameter set size identifying module may determine the model and its associated number of parameters that produce the least combined error. In other words, as explained in relation to FIG. 3 above, optimal parameter set size identifying module 516 may be configured to determine the optimal (i.e. least) combined error $f_{optimal}$ by evaluating the following algorithm:

$$f_{optimal} = \min\left\{{}_{N_{\min}}^{N}\left|f_{combined}(n)\right\}\right. = f_{combined}(n_{optimal})$$

Furthermore, after determining the minimum combined error, the optimal parameter set size identifying module 516 may determine the optimal parameter set size $n_{optimal}$ to generate a production data forecasting model by selecting the number $n$ of parameters that renders the minimum combined error.

In addition, production forecasting module 402 may include a target geological region modeling module 518, which may be configured to model the target geological region and forecast or otherwise predict one or more future production data values 520 using a selected parameter set as input, where this inputted selected parameter set has a size corresponding to the optimal parameter set size $n_{optimal}$.

In an example, target geological region modeling module 518 may determine parameter values of the selected parameter set of optimal parameter set size $n_{optimal}$ for forecasting future production data by using one or more fitting algorithms available in the art, which may include one or more fitting algorithms cited and/or described herein (e.g. in reference to fitting algorithms 508 of fitting error determining module and/or the fitting algorithms presented in reference to FIG. 1). Furthermore, in some examples, target geological region modeling module 518 may determine parameter values to be inputted for forecasting by using a full historical set of historical production data values, which may include a first set of historical production data values 102 (FIG. 1) and a second set of historical production data 206 (FIG. 2). In other words, target geological region modeling module 518 may be configured to forecast the future production data values 520 by estimating parameter values of the selected parameter set (that are used as forecasting model input), and may perform such estimation based on a full history of historical production data values.

In an additional example, parameter value estimation of the fitting models utilized by target geological region modeling module 518 may be computed based on minimization of sum of square errors between a full set of historical production data values and modeled production data vector 100 (see FIG. 1) via one or more numerical or mathematical optimization methods, which may be based on, but are not limited to, parameterization techniques involving mathematical transformations such as principal component analysis, kernel principal component analysis, discrete cosine transformation, adaptive spatial zonation, and coarsening of the reservoir model, or any other numerical optimization method.

Referring again to FIGS. 1 and 2, this full history may use all historical production data values up to point T as a basis for estimating these inputted parameters of the optimal size parameter set. As shown in FIGS. 1 and 2, this full history may comprise all historical production data values observed before (or at) time $T$, which may include the first set of historical production data 102 observed before (or at) time $t_{fit}$ and the second set of historical production data 206 observed during (inclusively or exclusively) the time interval $t_{fit}$ to $T$.

In addition, in some examples, target geological region modeling module 518 may be configured to determine the values of the parameters of the selected parameter set for forecasting future production data by first obtaining modeled data through use of a simulation model, such as a fitting model, based on the first and second sets of historical production data. Additionally, the simulation model may include any modeling method described herein. For example, based on the first and second sets of historical production data, the target geological region modeling module may obtain modeled data by estimating one or more parameters that are utilized as input to the model. Furthermore, in some examples, target geological region modeling module 518 may be further configured to identify the selected parameter set values by determining a minimum fitting error between the modeled data for the selected parameter set and the first and second sets of historical production data. For example, target geological region modeling module 518 may be configured to select the set of estimated parameter values from the modeling that minimizes the fitting error as the selected parameter set values.

Furthermore, in some non-limiting examples, target geological region modeling module 518 may use one or more numerical simulation techniques to forecast future production values, based on, but are not limited to, full-physics or streamline simulation, wherein the estimated parameter values of the selected parameter set are used as input for the simulation. Thus, production forecasting module 402 may be configured to execute a systematic methodology for estimation of a target reservoir model to forecast future production data using cross-validation that avoids the high processing needs of high resolution models while ensuring increased prediction capability of model for a target geological region.

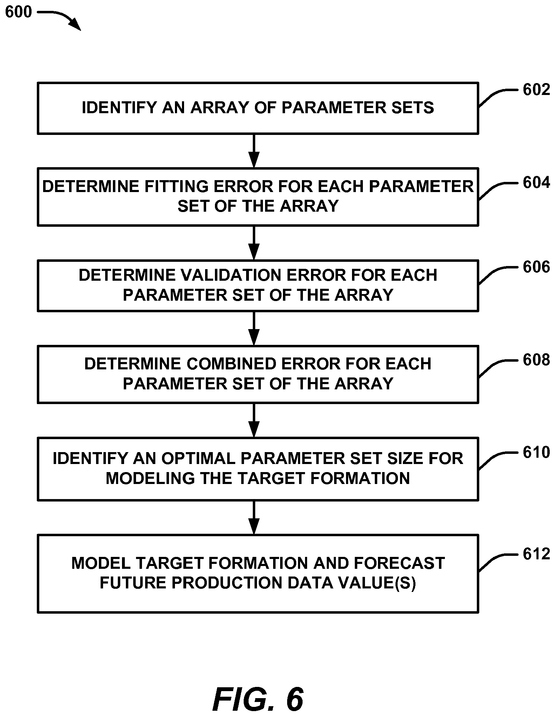

Turning to FIG. 6, an example methodology 600 is presented for forecasting production data using an improved model based on cross-validation techniques. In an example, methodology 600 may include identifying an array of parameter sets at block 602. In an example, the array of parameter sets may include one or more estimated parameter values corresponding to physical characteristics of a target geological region (e.g. an underground reservoir and/or surrounding region), which may include, for example, permeability, porosity, or any other physical, chemical, electrical, magnetic, or other characteristic of the target geological region. Furthermore, the parameter values of the parameter sets may be identified by estimating their values based on historical production data of hydrocarbon production and modeled production data derived from this historical production data. At block 602, identifying an array of parameter sets may include reading the array of parameter sets from a memory, such as a memory of a computer device, and/or the array of parameter sets may be inputted by a user. Furthermore, each parameter set of the array may include a unique number of parameters, wherein the parameters are estimated by modeling the target geological region based on historical production data.

In addition, methodology 600 may include determining a fitting error for each parameter set of the array. In an example, determining the fitting error for each parameter set of the array may include modeling a production data vector based on parameters derived from historical production data of hydrocarbon production and comparing the values of the modeled production data vector to the historical production data of hydrocarbon production. In an example, block 604 may include performing one or more of the methodologies described in relation to FIG. 1 and/or fitting error determining module 506 of FIG. 5.

Furthermore, methodology 600 may include determining a validation error for each parameter set of the array. In an example, determining the validation error for each parameter set of the array may include separating a modeling timeframe into a first sub-timeframe and a second sub-timeframe. In some examples, the modeling timeframe may comprise a time interval beginning at some first measurement point in the past and ending, for example, at a present time $T$. Furthermore, the first sub-timeframe may include a time interval preceding a time point $t_{fit}$ and the second sub-timeframe may include a time interval immediately following $t_{fit}$ and ending, in some examples, at point $T$. In other words, for a modeling timeframe spanning a first measurement time point (referred to here as "0") to time $T$, block 606 may include separating the modeling timeframe into a first sub-timeframe $0 < t \le t_{fit}$ and a second sub-timeframe $t_{fit} < t \le T$. For purposes of the present disclosure, historical production data measured during the first sub-timeframe may be referred to as a first set of historical production data of hydrocarbon production and historical production data measured during the second sub-timeframe may be referred to as a second set of historical production data of hydrocarbon production of the target geological region.

In addition, block 606 may further include the act of determining modeled production data associated with the second sub-timeframe based on the model with parameter values equal to the estimates determined according to the fitting model at block 604. In other words, determining the validation error for each parameter set of the array at block 606 may include extrapolating or forecasting a fitting model modeled production data vector past time $t_{fit}$ and into the second sub-timeframe up to time $T$ for each parameter set of an array of parameter sets.

Furthermore, determining the validation error for each parameter set of the array at block 606 may include comparing the second sub-timeframe modeled production data, referred to herein as the extrapolated production data, to production data measured during the second sub-timeframe to determine the validation error associated with the extrapolated or forecasted fitting model modeled production data vector over the second sub-timeframe. In an example, this comparison of the extrapolated production data to production data measured during the second sub-timeframe may include computing a squared error between the extrapolated production data to production data measured during the second sub-timeframe. In a further example, block 606 may include performing one or more of the methodologies described in relation to FIG. 2 and/or validation error determining module 510 of FIG. 5.

Moreover, methodology 600 may include determining a combined error for each parameter set of the array at block 608. In an example, block 608 may include summing the fitting error (of block 604) and the validation error (of block 608) to determine the combined error for each parameter set of the array. In some examples, the fitting error or the validation error may be weighted in the determination of the combined error. Furthermore, block 608 may include performing one or more of the methodologies described in relation to FIG. 3 and/or combined error determining module 514 of FIG. 5.

Additionally, methodology 600 may include identifying an optimal parameter set size for modeling the target geological region at block 610. In an example, the optimal parameter set size may correspond to the parameter size that resulted in a minimum combined error based on the results of block 608. In an example, therefore, block 610 may include determining a minimum combined error of the combined errors determined at block 608. In addition, block 610 may include performing one or more of the methodologies described in relation to FIG. 3 and/or optimal parameter set size identifying module 516 of FIG. 5.

Furthermore, at block 612, methodology 600 may include forecasting or otherwise predicting one or more future production values of the target geological region by modeling the target geological region using a selected parameter set having an optimal parameter set size determined at block 610. In an example, the selected parameter set values may be selected by determining a minimum fitting error between modeled data for the selected parameter set and the first and second sets of historical production data. In addition, block 612 may include performing one or more of the methodologies described in relation to target geological region modeling module 518 of FIG. 5.

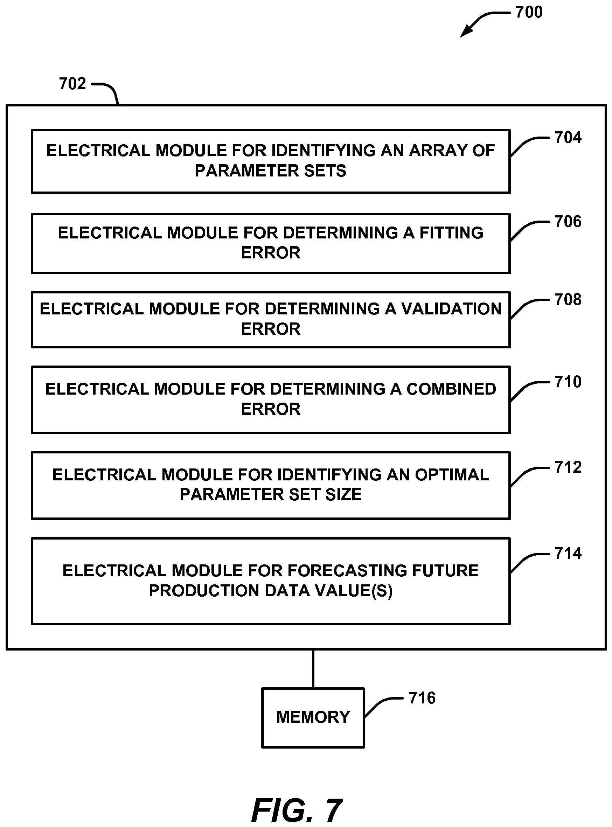

Referring to FIG. 7, an example system 700 is displayed for improved production data prediction using cross-validation. For example, system 700 can reside at least partially within a computer device (*e.g.* computer device 700 of FIG. 7). It is to be appreciated that system 700 is represented as including functional blocks, which can be functional blocks that represent functions implemented by a processor, software, or combination thereof (*e.g.,* firmware). System 700 includes a logical grouping 702 of electrical modules that can act in conjunction. For instance, logical grouping 702 can include an electrical module 704 for identifying an array of parameter sets. In an example, electrical module 704 may comprise parameter identifying module 502 (FIG. 5). Additionally, logical grouping 702 can include an electrical module 706 for determining a fitting error. In an example, electrical module 706 may comprise fitting error determining module 510 (FIG. 5). In an additional example, logical grouping 702 can include an electrical module 708 for determining a validation error. In an example, electrical module 708 may comprise validation error determining module 510 (FIG. 5). Furthermore, logical grouping 702 can include an electrical module 710 for determining a combined error. In an example, electrical module 710 may comprise combined error determining module 514 (FIG. 5). Furthermore, logical grouping 702 can include an electrical module 712 for identifying an optimal parameter set size. In an example, electrical module 712 may comprise optimal parameter set size identifying module 516 (FIG. 5). Furthermore, logical grouping 702 can include an electrical module 714 for modeling a target geological region and/or predicting future production data values. In an example, electrical module 714 may comprise target geological region modeling module 518 (FIG. 5).

Additionally, system 700 can include a memory 716 that retains instructions for executing functions associated with the electrical modules 704, 706, 708, 710, 712, and 714, stores data used or obtained by the electrical modules 704, 706, 708, 710, 712, and 714, *etc.* While shown as being external to memory 716, it is to be understood that one or more of the electrical modules 704, 706, 708, 710, 712, and 714 can exist within memory 716. In one example, electrical modules 704, 706, 708, 710, 712, and 714 can comprise at least one processor, or each electrical module 704, 706, 708, 710, 712, and 714 can be a corresponding module of at least one processor. Moreover, in an additional or alternative example, electrical modules 704, 706, 708, 710, 712, and 714 can be a computer program product including a computer readable medium, where each electrical module 704, 706, 708, 710, 712, and 714 can be corresponding code.

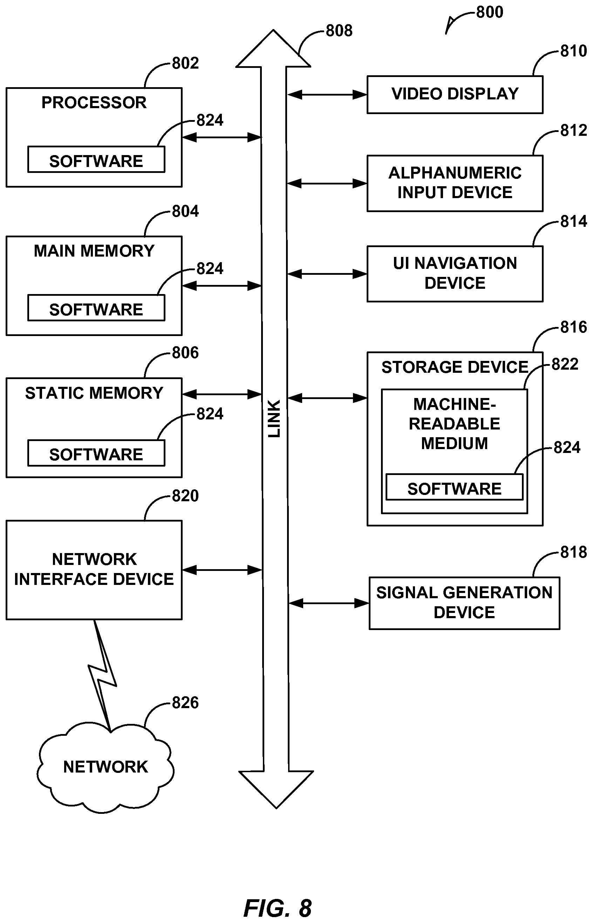

FIG. 8 is a block diagram illustrating a machine in the example form of a computer system 800, which may comprise computer device 400 of FIG. 4, within which a set or sequence of instructions for causing the machine to perform any one of the methodologies discussed herein may be executed, according to an example embodiment. In alternative embodiments, the machine operates as a standalone device or may be connected (*e.g.,* networked) to other machines. In a networked deployment, the machine may operate in the capacity of either a server or a client machine in server-client network environments, or it may act as a peer machine in peer-to-peer (or distributed) network environments. The machine may be a personal computer (PC), a tablet PC, a set-top box (STB), a Personal Digital Assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein.

Example computer system 800 includes at least one processor 802 (*e.g.,* a central processing unit (CPU), a graphics processing unit (GPU) or both, processor cores, compute nodes, etc.), a main memory 804 and a static memory 805, which communicate with each other via a link 808 (e.g., bus). The computer system 800 may further include a video display unit 810, an alphanumeric input device 812 (*e.g.,* a keyboard), and a user interface (UI) navigation device 814 (*e.g.,* a mouse). In one embodiment, the video display unit 810, input device 812 and UI navigation device 814 are incorporated into a touch screen display. The computer system 800 may additionally include a storage device 815 (*e.g.,* a drive unit), a signal generation device 818 (*e.g.,* a speaker), a network interface device 820, and one or more sensors (not shown), such as a global positioning system (GPS) sensor, compass, accelerometer, or other sensor.

The storage device 815 includes a machine-readable storage medium 822 on which is stored one or more sets of data structures and/or instructions 824 (*e.g.,* software) embodying or utilized by any one or more of the methodologies or functions described herein. The instructions 824 may also reside, completely or at least partially, within the main memory 804, static memory 805, and/or within the processor 802 during execution thereof by the computer system 800, with the main memory 804, static memory 805, and cache memory of the processor 802 also constituting machine-readable storage media.

While the machine-readable storage medium 822 is illustrated in an example embodiment to be a single medium, the term "machine-readable storage medium" may include a single medium or multiple media (*e.g.,* a centralized or distributed database, and/or associated caches and servers) that store the one or more instructions 824. The term "machine-readable storage medium" shall also be taken to include any tangible medium that is capable of storing either instruction for execution by the machine or data. The term "machine-readable storage medium" shall accordingly be taken to include, but not be limited to, solid-state memories, and optical and magnetic media. Specific examples of machine-readable storage media include non-volatile memory, including, by way of example, semiconductor memory devices (*e.g.,* Electrically Programmable Read-Only Memory (EPROM), Electrically Erasable Programmable Read-Only Memory (EEPROM)) and flash memory devices; magnetic disks such as internal hard disks and removable disks; magneto-optical disks; and CD-ROM and DVD-ROM disks.

The instructions 824 may further be transmitted or received over a communications network 826 using a transmission medium via the network interface device 820 utilizing any one of a number of well-known transfer protocols (*e.g.,* HTTP). Examples of communication networks include a local area network (LAN), a wide area network (WAN), the Internet, mobile telephone networks, Plain Old Telephone (POTS) networks, and wireless data networks (*e.g.,* Wi-Fi, 3G, and 4G LTE/LTE-A or WiMAX networks). The term "transmission medium" shall be taken to include any intangible medium that is capable of storing, encoding, or carrying instructions for execution by the machine, and includes digital or analog communications signals or other intangible medium to facilitate communication of such software.

Examples are described herein, can include, or can operate on, logic or a number of modules or mechanisms. Modules are tangible entities capable of performing specified operations and can be configured or arranged in a certain manner. In an example, circuits can be arranged (*e.g.,* internally or with respect to external entities such as other circuits) in a specified manner as a module. In an example, the whole or part of one or more computer systems (*e.g.,* a standalone, client or server computer system) or one or more hardware processors can be configured by firmware or software (*e.g.,* instructions, an application portion, or an application) as a module that operates to perform specified operations. In an example, the software can reside (1) on a non-transitory machine-readable medium or (2) in a transmission signal. In an example, the software, when executed by the underlying hardware of the module, causes the hardware to perform the specified operations.

Accordingly, the term "module" is understood to encompass a tangible entity, be that an entity that is physically constructed, specifically configured (*e.g.,* hardwired), or temporarily (*e.g.,* transitorily) configured (*e.g.,* programmed) to operate in a specified manner or to perform part or all of any operation described herein. Considering examples in which modules are temporarily configured, one instantiation of a module may not exist simultaneously with another instantiation of the same or different module. For example, where the modules comprise a general-purpose hardware processor configured using software, the general-purpose hardware processor can be configured as respective different modules at different times. Accordingly, software can configure a hardware processor, for example, to constitute a particular module at one instance of time and to constitute a different module at a different instance of time.

Additional examples of the presently described method, system, and device embodiments include the following, non-limiting configurations. Each of the following non-limiting examples may stand on its own, or may be combined in any permutation or combination with any one or more of the other examples provided below or throughout the present disclosure. The preceding description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments.

**Claims**

1.  A method of determining a geological model, comprising the acts of:
    identifying (602) an array of parameter sets, wherein each parameter set is of a unique size and contains values of geological parameters estimated from historical production data (102) associated with a target geological region;
    **characterized by** the following steps:

    determining (604) a fitting error (104,302) between a first set of the historical production data (102) and modeled production data (100), wherein the modeled production data (100) is obtained through execution of a simulation model based on each parameter set of the array;
    determining (606) a validation error (204,304) between a second set of the historical production data (204) and extrapolated production data for each parameter set of the array, wherein the extrapolated production data is obtained based on the modeled production data (100) for the respective parameter set of the array;
    determining (608) a combined error for each parameter set of the array based on the fitting error (104,302) and the validation error (204,304); and
    identifying (610) an optimal parameter set size (310) for modeling the target geological region, wherein the optimal parameter set size (310) is determined in reference to a minimum combined error (308) of the combined errors (306) determined for each parameter set of the array.

2.  The method of claim 1, further comprising:

modeling (612) the target geological region using a selected parameter set of the identified optimal parameter set size (310) and using selected parameter set values estimated based on the first and second sets of historical production data (102); and

forecasting future production data (100) for the target geological region using a forecasting simulation model utilizing the selected parameter set.

3. The method of claim 2, wherein the selected parameter set values are determined by the acts of:

obtaining modeled data for the selected parameter set through use of a simulation model based on the first and second sets of historical production data (102); and

identifying (602) the selected parameter set values by determining a minimum fitting error (104,302) between the modeled data for the selected parameter set and the first and second sets of historical production data (102).

4. The method of claim 1, wherein determining (606) the validation error (204,304) for each parameter set of the array comprises:

separating a modeling timeframe into a first sub-timeframe and a second sub-timeframe;

determining forecast of second sub-timeframe production data (100) based on the simulation model with geological parameter values equal to the estimates determined according to the fitting model of the first sub-timeframe; and

comparing the second sub-timeframe forecasted production data (100) to production data measured during the second sub-timeframe.

5. The method of claim 4, wherein comparing the second sub-timeframe forecasted production data (100) to production data measured during the second sub-timeframe comprises computing a squared error between the second sub-timeframe forecasted production data (100) to the production data measured during the second sub-timeframe.

6. The method of claim 1, wherein determining (606) the validation error (204,304) for each parameter set of the array comprises performing cross-validation.

7. The method of claim 1, wherein identifying (610) the optimal parameter set size (310) further comprises minimizing the fitting error (104,302) for each parameter set of the array.

8. The method of claim 1, wherein identifying (610) the optimal parameter set size (310) further comprises minimizing the combined error (306) for each parameter set of the array.

9. An apparatus (700,800) for determining a geological model, comprising:

one or more processors (802), and

a machine readable storage device (804,805,822) comprising instructions that when executed by the one or more processors (802), perform operations comprising,

identifying an array of parameter sets, wherein each parameter set is of a unique size and contains values of geological parameters estimated from historical production data (102) associated with a target geological region (704); **characterized by** the following features:

determining a fitting error (104,302) between a first set of the historical production data (102) and modeled production data (100), wherein the modeled production data is obtained through execution of a simulation model based on each parameter set of the array (706);

determining a validation error (204,304) between a second set of the historical production data (102) and extrapolated production data for each parameter set of the array, wherein the extrapolated production data is obtained based on the modeled production data for the respective parameter set of the array (708);

determining a combined error (306) for each parameter set of the array (710) based on the fitting error (104,302) and the validation error (204,304); and

identifying an optimal parameter set size (310) for modeling the target geological region, wherein the optimal parameter set size (310) is determined in reference to a minimum combined error (308) of the combined errors (306) determined for each parameter set of the array (712).

10. The apparatus (700,800) of claim 9, wherein operations further comprise:

## EP 2 981 866 B1

modeling the target geological region using a selected parameter set of the identified optimal parameter set size (310) and using selected parameter set values estimated based on the first and second sets of historical production data (102); and

forecasting future production data (100) for the target geological region using a forecasting simulation model utilizing the selected parameter set (714).

11. The apparatus (700,800) of claim 10, wherein the operations further comprise:

obtaining modeled data for the selected parameter set through use of a simulation model based on the first and second sets of historical production data (102); and

identifying the selected parameter set values by determining a minimum fitting error (104,302) between the modeled data for the selected parameter set and the first and second sets of historical production data (102).

12. The apparatus (700,800) of claim 11, wherein the operation of determining the validation error (204,304) for each parameter set of the array comprises:

separating a modeling timeframe into a first sub-timeframe and a second sub-timeframe;

determining forecast of second sub-timeframe production data (100) based on the simulation model with geological parameter values equal to the estimates determined according to the fitting model of the first sub-timeframe; and

comparing the second sub-timeframe forecasted production data (100) to production data measured during the second sub-timeframe.

13. The apparatus (700,800) of claim 12, wherein comparing the second sub-timeframe forecasted production data (100) to production data measured during the second sub-timeframe comprises computing a squared error between the second sub-timeframe forecasted production data (100) to the production data measured during the second sub-timeframe.

14. The apparatus (700,800) of claim 9, wherein the operation of determining the validation error (204,304) for each parameter set of the array comprises performing cross-validation.

15. A non-transitory computer-readable medium comprising instructions that, when executed by a computer, cause the computer to perform operations comprising:

identifying (602) an array of parameter sets, wherein each parameter set is of a unique size and contains values of geological parameters estimated from historical production data (102) associated with a target geological region; **characterized by** the following features:

determining (604) a fitting error (104,302) between a first set of the historical production data (102) and modeled production data (100), wherein the modeled production data (100) is obtained through execution of a simulation model based on each parameter set of the array;

determining (606) a validation error (204,304) between a second set of the historical production data (102) and extrapolated production data for each parameter set of the array, wherein the extrapolated production data is obtained based on the modeled production data (100) for the respective parameter set of the array;

determining (608) a combined error (306) for each parameter set of the array based on the fitting error (104,302) and the validation error (204,304); and

identifying (610) an optimal parameter set size (310) for modeling the target geological region, wherein the optimal parameter set size (310) is determined in reference to a minimum combined error (308) of the combined errors (306) determined for each parameter set of the array.

**Patentansprüche**

1. Verfahren zum Bestimmen eines geologischen Modells, das folgende Handlungen umfasst:

Ermitteln (602) einer Reihe von Parametersätzen, wobei jeder Parametersatz eine eindeutige Größe aufweist und Werte geologischer Parameter enthält, die anhand historischer Produktionsdaten (102) geschätzt werden, die mit einer geologischen Zielregion zusammenhängen; durch die folgenden Schritte gekennzeichnet:

Bestimmen (604) eines Anpassungsfehlers (104, 302) zwischen einem ersten Satz der historischen Produktionsdaten (102) und modellierten Produktionsdaten (100), wobei die modellierten Produktionsdaten (100) durch das Ausführen eines Simulationsmodells, das auf jedem Parametersatz der Reihe basiert, erhalten werden;

Bestimmen (606) eines Überprüfungsfehlers (204, 304) zwischen einem zweiten Satz der historischen Produktionsdaten (204) und extrapolierten Produktionsdaten für jeden Parametersatz der Reihe, wobei die extrapolierten Produktionsdaten basierend auf den modellierten Produktionsdaten (100) für den jeweiligen Parametersatz der Reihe erhalten werden;

Bestimmen (608) eines zusammengesetzten Fehlers für jeden Parametersatz der Reihe, basierend auf dem Anpassungsfehler (104, 302) und dem Überprüfungsfehler (204, 304); und

Ermitteln (610) einer optimalen Parametersatzgröße (310) für das Modellieren der geologischen Zielregion, wobei die optimale Parametersatzgröße (310) in Bezug auf einen minimalen zusammengesetzten Fehler (308) der zusammengesetzten Fehler (306), die für jeden Parametersatz der Reihe bestimmt werden, bestimmt wird.

2. Verfahren nach Anspruch 1, das ferner Folgendes umfasst:

Modellieren (612) der geologischen Zielregion unter Verwendung eines ausgewählten Parametersatzes der ermittelten optimalen Parametersatzgröße (310) und unter Verwendung ausgewählter Parametersatzwerte, die basierend auf den ersten und zweiten Sätzen historischer Produktionsdaten (102) geschätzt werden; und Prognostizieren künftiger Produktionsdaten (100) für die geologische Zielregion unter Verwendung eines Prognosesimulationsmodells, bei dem der ausgewählte Parametersatz zur Anwendung kommt.

3. Verfahren nach Anspruch 2, wobei die ausgewählten Parametersatzwerte durch folgende Handlungen bestimmt werden:

Erhalten modellierter Daten für den ausgewählten Parametersatz durch das Nutzen eines Simulationsmodells, das auf den ersten und zweiten Sätzen historischer Produktionsdaten (102) basiert; und Ermitteln (602) der ausgewählten Parametersatzwerte durch Bestimmen eines minimalen Anpassungsfehlers (104, 302) zwischen den modellierten Daten für den ausgewählten Parametersatz und den ersten und zweiten Sätzen historischer Produktionsdaten (102) .

4. Verfahren nach Anspruch 1, wobei das Bestimmen (606) des Überprüfungsfehlers (204, 304) für jeden Parametersatz der Reihe Folgendes umfasst:

Trennen eines Modellierungszeitrahmens in einen ersten Unterzeitrahmen und einen zweiten Unterzeitrahmen; Bestimmen einer Prognose von Produktionsdaten (100) des zweiten Unterzeitrahmens, basierend auf dem Simulationsmodell mit geologischen Parameterwerten, die den Schätzungen entsprechen, die gemäß dem Anpassungsmodell des ersten Unterzeitrahmens bestimmt werden; und Vergleichen der prognostizierten Produktionsdaten (100) des zweiten Unterzeitrahmens mit während des zweiten Unterzeitrahmens gemessenen Produktionsdaten.

5. Verfahren nach Anspruch 4, wobei das Vergleichen der prognostizierten Produktionsdaten (100) des zweiten Unterzeitrahmens mit während des zweiten Unterzeitrahmens gemessenen Produktionsdaten das Berechnen eines quadrierten Fehlers zwischen den prognostizierten Produktionsdaten (100) des zweiten Unterzeitrahmens mit den während des zweiten Unterzeitrahmens gemessenen Produktionsdaten umfasst.

6. Verfahren nach Anspruch 1, wobei das Bestimmen (606) des Überprüfungsfehlers (204, 304) für jeden Parametersatz der Reihe das Durchführen einer Vergleichsprüfung umfasst.

7. Verfahren nach Anspruch 1, wobei das Identifizieren (610) der optimalen Parametersatzgröße (310) ferner das Minimieren des Anpassungsfehlers (104, 302) für jeden Parametersatz der Reihe umfasst.

8. Verfahren nach Anspruch 1, wobei das Identifizieren (610) der optimalen Parametersatzgröße (310) ferner das Minimieren des zusammengesetzten Fehlers (306) für jeden Parametersatz der Reihe umfasst.

9. Vorrichtung (700, 800) für das Bestimmen eines geologischen Modells, die Folgendes umfasst:

einen oder mehrere Prozessoren (802), und eine maschinenlesbare Speichervorrichtung (804, 805, 822), die Anweisungen umfasst, die, wenn sie von dem einen oder den mehreren Prozessoren (802) ausgeführt werden, Abläufe durchführen, die Folgendes umfassen:

Ermitteln einer Reihe von Parametersätzen, wobei jeder Parametersatz eine eindeutige Größe aufweist und Werte geologischer Parameter enthält, die anhand historischer Produktionsdaten (102) geschätzt werden, die mit einer geologischen Zielregion (704) zusammenhängen; durch die folgenden Merkmale gekennzeichnet:

Bestimmen eines Anpassungsfehlers (104, 302) zwischen einem ersten Satz der historischen Produktionsdaten (102) und modellierten Produktionsdaten (100), wobei die modellierten Produktionsdaten durch das Ausführen eines Simulationsmodells, das auf jedem Parametersatz der Reihe (706) basiert, erhalten werden;

Bestimmen eines Überprüfungsfehlers (204, 304) zwischen einem zweiten Satz der historischen Produktionsdaten (102) und extrapolierten Produktionsdaten für jeden Parametersatz der Reihe, wobei die extrapolierten Produktionsdaten basierend auf den modellierten Produktionsdaten für den jeweiligen Parametersatz der Reihe (708) erhalten werden;

Bestimmen eines zusammengesetzten Fehlers (306) für jeden Parametersatz der Reihe (710), basierend auf dem Anpassungsfehler (104, 302) und dem Überprüfungsfehler (204, 304); und

Ermitteln einer optimalen Parametersatzgröße (310) für das Modellieren der geologischen Zielregion, wobei die optimale Parametersatzgröße (310) in Bezug auf einen minimalen zusammengesetzten Fehler (308) der zusammengesetzten Fehler (306), die für jeden Parametersatz der Reihe (712) bestimmt werden, bestimmt wird.

10. Vorrichtung (700, 800) nach Anspruch 9, wobei Abläufe ferner Folgendes umfassen:

Modellieren der geologischen Zielregion unter Verwendung eines ausgewählten Parametersatzes der ermittelten optimalen Parametersatzgröße (310) und unter Verwendung ausgewählter Parametersatzwerte, die basierend auf den ersten und zweiten Sätzen historischer Produktionsdaten (102) geschätzt werden; und

Prognostizieren künftiger Produktionsdaten (100) für die geologische Zielregion unter Verwendung eines Prognosesimulationsmodells, bei dem der ausgewählte Parametersatz (714) zur Anwendung kommt.

11. Vorrichtung (700, 800) nach Anspruch 10, wobei die Abläufe ferner Folgendes umfassen:

Erhalten modellierter Daten für den ausgewählten Parametersatz durch das Nutzen eines Simulationsmodells, das auf den ersten und zweiten Sätzen historischer Produktionsdaten (102) basiert; und

Ermitteln der ausgewählten Parametersatzwerte durch Bestimmen eines minimalen Anpassungsfehlers (104, 302) zwischen den modellierten Daten für den ausgewählten Parametersatz und den ersten und zweiten Sätzen historischer Produktionsdaten (102) .

12. Vorrichtung (700, 800) nach Anspruch 11, wobei der Ablauf des Bestimmens des Überprüfungsfehlers (204, 304) für jeden Parametersatz der Reihe Folgendes umfasst:

Trennen eines Modellierungszeitrahmens in einen ersten Unterzeitrahmen und einen zweiten Unterzeitrahmen;

Bestimmen einer Prognose von Produktionsdaten (100) des zweiten Unterzeitrahmens, basierend auf dem Simulationsmodell mit geologischen Parameterwerten, die den Schätzungen entsprechen, die gemäß dem Anpassungsmodell des ersten Unterzeitrahmens bestimmt werden; und

Vergleichen der prognostizierten Produktionsdaten (100) des zweiten Unterzeitrahmens mit während des zweiten Unterzeitrahmens gemessenen Produktionsdaten.

13. Vorrichtung (700, 800) nach Anspruch 12, wobei das Vergleichen der prognostizierten Produktionsdaten (100) des zweiten Unterzeitrahmens mit während des zweiten Unterzeitrahmens gemessenen Produktionsdaten das Berechnen eines quadrierten Fehlers zwischen den prognostizierten Produktionsdaten (100) des zweiten Unterzeitrahmens mit den während des zweiten Unterzeitrahmens gemessenen Produktionsdaten umfasst.

14. Vorrichtung (700, 800) nach Anspruch 9, wobei der Ablauf des Bestimmens des Überprüfungsfehlers (204, 304) für jeden Parametersatz der Reihe das Durchführen einer Vergleichsprüfung umfasst.

15. Nicht vorübergehendes computerlesbares Medium, das Anweisungen umfasst, die, wenn sie von einem Computer ausgeführt werden, den Computer veranlassen, Abläufe durchzuführen, die Folgendes umfassen:
Ermitteln (602) einer Reihe von Parametersätzen, wobei jeder Parametersatz eine eindeutige Größe aufweist und Werte geologischer Parameter enthält, die anhand historischer Produktionsdaten (102) geschätzt werden, die mit einer geologischen Zielregion zusammenhängen; durch die folgenden Merkmale gekennzeichnet:

Bestimmen (604) eines Anpassungsfehlers (104, 302) zwischen einem ersten Satz der historischen Produktionsdaten (102) und modellierten Produktionsdaten (100), wobei die modellierten Produktionsdaten (100) durch das Ausführen eines Simulationsmodells, das auf jedem Parametersatz der Reihe basiert, erhalten werden;

Bestimmen (606) eines Überprüfungsfehlers (204, 304) zwischen einem zweiten Satz der historischen Produktionsdaten (102) und extrapolierten Produktionsdaten für jeden Parametersatz der Reihe, wobei die extrapolierten Produktionsdaten basierend auf den modellierten Produktionsdaten (100) für den jeweiligen Parametersatz der Reihe erhalten werden;

Bestimmen (608) eines zusammengesetzten Fehlers (306) für jeden Parametersatz der Reihe, basierend auf dem Anpassungsfehler (104, 302) und dem Überprüfungsfehler (204, 304); und

Ermitteln (610) einer optimalen Parametersatzgröße (310) für das Modellieren der geologischen Zielregion, wobei die optimale Parametersatzgröße (310) in Bezug auf einen minimalen zusammengesetzten Fehler (308) der zusammengesetzten Fehler (306), die für jeden Parametersatz der Reihe bestimmt werden, bestimmt wird.

## Revendications

1. Procédé permettant de déterminer un modèle géologique, comprenant les actes :
d'identification (602) d'un réseau d'ensembles de paramètres, dans lequel chaque ensemble de paramètres est d'une taille unique et contient des valeurs de paramètres géologiques estimées à partir de données de production historiques (102) associées à une région géologique cible ; **caractérisé par** les étapes suivantes :

la détermination (604) d'une erreur d'adaptation (104, 302) entre un premier ensemble des données de production historiques (102) et des données de production modélisées (100), dans lequel les données de production modélisées (100) sont obtenues par l'exécution d'un modèle de simulation sur la base de chaque ensemble de paramètres du réseau ;

la détermination (606) d'une erreur de validation (204, 304) entre un second ensemble des données de production historiques (204) et des données de production extrapolées pour chaque ensemble de paramètres du réseau, dans lequel les données de production extrapolées sont obtenues sur la base des données de production modélisées (100) pour l'ensemble de paramètres respectif du réseau ;

la détermination (608) d'une erreur combinée pour chaque ensemble de paramètres du réseau sur la base de l'erreur d'adaptation (104, 302) et de l'erreur de validation (204, 304) ; et

l'identification (610) d'une taille d'ensemble de paramètres optimale (310) pour modéliser la région géologique cible, dans lequel la taille d'ensemble de paramètres optimale (310) est déterminée en référence à une erreur combinée minimale (308) des erreurs combinées (306) déterminées pour chaque ensemble de paramètres du réseau.

2. Procédé selon la revendication 1, comprenant en outre :

la modélisation (612) de la région géologique cible en utilisant un ensemble de paramètres sélectionné de la taille d'ensemble de paramètres optimale identifiée (310) et en utilisant des valeurs d'ensemble de paramètres sélectionnées estimées sur la base des premier et second ensembles de données de production historiques (102) ; et

la prévision de données de production futures (100) pour la région géologique cible en utilisant un modèle de simulation de prévision utilisant l'ensemble de paramètres sélectionné.

3. Procédé selon la revendication 2, dans lequel les valeurs d'ensemble de paramètres sélectionnées sont déterminées par les actes :

d'obtention de données modélisées pour l'ensemble de paramètres sélectionné en utilisant un modèle de simulation sur la base des premier et second ensembles de données de production historiques (102) ; et

l'identification (602) des valeurs d'ensemble de paramètres sélectionnées en déterminant une erreur d'adaptation minimale (104, 302) entre les données modélisées pour l'ensemble de paramètres sélectionné et les premier et second ensembles de données de production historiques (102).

4. Procédé selon la revendication 1, dans lequel la détermination (606) de l'erreur de validation (204 304) pour chaque ensemble de paramètres du réseau comprend :

la séparation d'une période de modélisation en une première sous-période et une seconde sous-période ;

la détermination de la prévision de secondes données de production de sous-période (100) sur la base du modèle de simulation avec des valeurs de paramètres géologiques égales aux estimations déterminées selon le modèle d'adaptation de la première sous-période ; et

la comparaison des secondes données de production prévues de sous-période (100) avec les données de production mesurées pendant la seconde sous-période.

5. Procédé selon la revendication 4, dans lequel la comparaison des secondes données de production prévues de sous-période (100) avec les données de production mesurées pendant la seconde sous-période comprend le calcul d'une erreur quadratique entre les secondes données de production prévues de sous-période (100) et les données de production mesurées pendant la seconde sous-période.

6. Procédé selon la revendication 1, dans lequel la détermination (606) de l'erreur de validation (204, 304) pour chaque ensemble de paramètres du réseau comprend l'exécution d'une validation croisée.

7. Procédé selon la revendication 1, dans lequel l'identification (610) de la taille d'ensemble de paramètres optimale (310) comprend en outre la minimisation de l'erreur d'adaptation (104, 302) pour chaque ensemble de paramètres du réseau.

8. Procédé selon la revendication 1, dans lequel l'identification (610) de la taille d'ensemble de paramètres optimale (310) comprend en outre la minimisation de l'erreur combinée (306) pour chaque ensemble de paramètres du réseau.

9. Appareil (700, 800) permettant de déterminer un modèle géologique, comprenant :

un ou plusieurs processeurs (802), et
un dispositif de stockage lisible par machine (804, 805, 822) comprenant des instructions qui, lorsqu'elles sont exécutées par les un ou plusieurs processeurs (802), effectuent des opérations comprenant,
l'identification d'un réseau d'ensembles de paramètres, dans lequel chaque ensemble de paramètres est d'une taille unique et contient des valeurs de paramètres géologiques estimées à partir de données de production historiques (102) associées à une région géologique cible (704) ; **caractérisé par** les caractéristiques suivantes :

la détermination d'une erreur d'adaptation (104, 302) entre un premier ensemble des données de production historiques (102) et des données de production modélisées (100), dans lequel les données de production modélisées sont obtenues par l'exécution d'un modèle de simulation sur la base de chaque ensemble de paramètres du réseau (706) ;
la détermination d'une erreur de validation (204, 304) entre un second ensemble des données de production historiques (102) et des données de production extrapolées pour chaque ensemble de paramètres du réseau, dans lequel les données de production extrapolées sont obtenues sur la base des données de production modélisées pour l'ensemble de paramètres respectif du réseau (708) ;
la détermination d'une erreur combinée (306) pour chaque ensemble de paramètres du réseau (710) sur la base de l'erreur d'adaptation (104, 302) et de l'erreur de validation (204, 304) ; et
l'identification d'une taille d'ensemble de paramètres optimale (310) pour modéliser la région géologique cible, dans lequel la taille d'ensemble de paramètres optimale (310) est déterminée en référence à une erreur combinée minimale (308) des erreurs combinées (306) déterminées pour chaque ensemble de paramètres du réseau (712).

10. Appareil (700, 800) selon la revendication 9, dans lequel les opérations comprennent en outre :

la modélisation de la région géologique cible en utilisant un ensemble de paramètres sélectionné de la taille d'ensemble de paramètres optimale identifiée (310) et en utilisant des valeurs d'ensemble de paramètres sélectionnées estimées sur la base des premier et second ensembles de données de production historiques (102) ; et
la prévision de données de production futures (100) pour la région géologique cible en utilisant un modèle de simulation de prévision utilisant l'ensemble de paramètres sélectionné (714) .

11. Appareil (700, 800) selon la revendication 10, dans lequel les opérations comprennent en outre :

l'obtention de données modélisées pour l'ensemble de paramètres sélectionné en utilisant un modèle de simulation sur la base des premier et second ensembles de données de production historiques (102) ; et

l'identification des valeurs d'ensemble de paramètres sélectionnées en déterminant une erreur d'adaptation minimale (104, 302) entre les données modélisées pour l'ensemble de paramètres sélectionné et les premier et second ensembles de données de production historiques (102).

12. Appareil (700 800) selon la revendication 11, dans lequel l'opération de détermination de l'erreur de validation (204, 304) pour chaque ensemble de paramètres du réseau comprend :

la séparation d'une période de modélisation en une première sous-période et une seconde sous-période ;
la détermination de la prévision de secondes données de production de sous-période (100) sur la base du modèle de simulation avec des valeurs de paramètres géologiques égales aux estimations déterminées selon le modèle d'adaptation de la première sous-période ; et
la comparaison des secondes données de production prévues de sous-période (100) avec les données de production mesurées pendant la seconde sous-période.

13. Appareil (700, 800) selon la revendication 12, dans lequel la comparaison des secondes données de production prévues de sous-période (100) avec les données de production mesurées pendant la seconde sous-période comprend le calcul d'une erreur quadratique entre les secondes données de production prévues de sous-période (100) et les données de production mesurées pendant la seconde sous-période.

14. Appareil (700, 800) selon la revendication 9, dans lequel l'opération de détermination de l'erreur de validation (204, 304) pour chaque ensemble de paramètres du réseau comprend l'exécution d'une validation croisée.

15. Support non transitoire lisible par ordinateur comprenant des instructions qui, lorsqu'elles sont exécutées par un ordinateur, amènent l'ordinateur à effectuer des opérations comprenant :
l'identification (602) d'un réseau d'ensembles de paramètres, dans lequel chaque ensemble de paramètres est d'une taille unique et contient des valeurs de paramètres géologiques estimées à partir de données de production historiques (102) associées à une région géologique cible ; **caractérisé par** les caractéristiques suivantes :

la détermination (604) d'une erreur d'adaptation (104, 302) entre un premier ensemble des données de production historiques (102) et des données de production modélisées (100), dans lequel les données de production modélisées (100) sont obtenues par l'exécution d'un modèle de simulation sur la base de chaque ensemble de paramètres du réseau ;
la détermination (606) d'une erreur de validation (204, 304) entre un second ensemble des données de production historiques (102) et des données de production extrapolées pour chaque ensemble de paramètres du réseau, dans lequel les données de production extrapolées sont obtenues sur la base des données de production modélisées (100) pour l'ensemble de paramètres respectif du réseau ;
la détermination (608) d'une erreur combinée (306) pour chaque ensemble de paramètres du réseau sur la base de l'erreur d'adaptation (104, 302) et de l'erreur de validation (204, 304) ; et
l'identification (610) d'une taille d'ensemble de paramètres optimale (310) pour modéliser la région géologique cible, dans lequel la taille d'ensemble de paramètres optimale (310) est déterminée en référence à une erreur combinée minimale (308) des erreurs combinées (306) déterminées pour chaque ensemble de paramètres du réseau.

FIG. 1

EP 2 981 866 B1

*FIG. 2*

FIG. 3

EP 2 981 866 B1

COMPUTING DEVICE 400

PRODUCTION FORECASTING
MODULE 402

# FIG. 4

PRODUCTION FORECASTING MODULE 402

PARAMETER IDENTIFYING MODULE 502

PARAMETER SET(S) 504

FITTING ERROR DETERMINING MODULE 506

FITTING ALGORITHM(S) 508

VALIDATION ERROR DETERMINING MODULE 510

VALIDATION ERROR ALGORITHM(S) 512

COMBINED ERROR DETERMINING MODULE 514

OPTIMAL PARAMETER SET SIZE IDENTIFYING MODULE 516

TARGET FORMATION MODELING MODULE 518

FUTURE PRODUCTION DATA VALUE(S) 520

FIG. 5

600 —↘

IDENTIFY AN ARRAY OF PARAMETER SETS — 602

↓

DETERMINE FITTING ERROR FOR EACH PARAMETER SET OF THE ARRAY — 604

↓

DETERMINE VALIDATION ERROR FOR EACH PARAMETER SET OF THE ARRAY — 606

↓

DETERMINE COMBINED ERROR FOR EACH PARAMETER SET OF THE ARRAY — 608

↓

IDENTIFY AN OPTIMAL PARAMETER SET SIZE FOR MODELING THE TARGET FORMATION — 610

↓

MODEL TARGET FORMATION AND FORECAST FUTURE PRODUCTION DATA VALUE(S) — 612

*FIG. 6*

700

702

ELECTRICAL MODULE FOR IDENTIFYING AN ARRAY OF PARAMETER SETS — 704

ELECTRICAL MODULE FOR DETERMINING A FITTING ERROR — 706

ELECTRICAL MODULE FOR DETERMINING A VALIDATION ERROR — 708

ELECTRICAL MODULE FOR DETERMINING A COMBINED ERROR — 710

ELECTRICAL MODULE FOR IDENTIFYING AN OPTIMAL PARAMETER SET SIZE — 712

ELECTRICAL MODULE FOR FORECASTING FUTURE PRODUCTION DATA VALUE(S) — 714

MEMORY — 716

*FIG. 7*

*FIG. 8*

**EP 2 981 866 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013080066 A